Europäisches Patentamt

**European Patent Office**

Office européen des brevets

(19)

(11) Numéro de publication: **0 149 951
B1**

(12) **FASCICULE DE BREVET EUROPEEN**

(45) Date de publication du fascicule du brevet:
**30.03.88**

(21) Numéro de dépôt: **84402767.2**

(22) Date de dépôt: **28.12.84**

(51) Int. Cl.⁴: **G 01 V 1/16,** H 03 F 1/26,
H 03 F 3/45

(54) **Procédé et dispositif de détection sismique.**

(30) Priorité: **29.12.83 FR 8320989**

(43) Date de publication de la demande:
**31.07.85 Bulletin 85/31**

(45) Mention de la délivrance du brevet:
**30.03.88 Bulletin 88/13**

(84) Etats contractants désignés:
**DE FR GB IT NL**

(56) Documents cités:
**DE - A - 3 307 575
US - A - 3 412 374
US - A - 3 863 200
US - A - 3 972 001**

**ELECTRONIC DESIGN, vol. 28, no. 26, décembre 1980,
pages 65-71, Waseca, Minnesota, US; G. ERDI et al.:
"Op amps tackle noise - and for once, noise loses"
WIRELESS WORLD, vol. 78, mai 1972, pages 233-237,
Hayward Heath, Sussex, GB; H.P. WALKER: "Low-noise
audio amplifiers"**

(73) Titulaire: **SOCIETE DE PROSPECTION ELECTRIQUE
SCHLUMBERGER, 42, rue Saint-Dominique,
F-75340 Paris Cedex 07 (FR)**

(84) Etats contractants désignés: **FR IT**

(73) Titulaire: **Schlumberger Limited, 277 Park Avenue, New
York, N.Y. 10172 (US)**

(84) Etats contractants désignés: **DE GB NL**

(72) Inventeur: **Jullien, François Marie Joseph, 15, Avenue
des Molières, F-78470 St. Rémy les Chevreuse (FR)**

(74) Mandataire: **Chareyron, Lucien et al, ETUDES ET
PRODUCTIONS SCHLUMBERGER Service Brevets
BP 202, F-92142 Clamart Cédex 07 (FR)**

## Description

La présente invention concerne l'acquisition de signaux sisimiques, et plus particulièrement un procédé et un dispositif de détection sisimique utilisant un capteur sismique composé d'un ou plusieurs géophones.

L'interprétation sismique, qu'elle soit de données de surface ou de fond, est d'une importance capitale pour la recherche pétrolière et la qualité de son résultat dépend en majeure partie de la qualité du signal sismique recueilli ainsi que de son traitement initial.

Pour capter les ondes sismiques, l'on utilise très souvent des capteurs, formés par un ou plusieurs géophones du type électromagnétique. Ces géophones comprennent essentiellement une bobine et un aimant dont l'un est fixe par rapport à la terre, tandis que l'autre est suspendu par l'intermédiaire d'un ressort à un support fixe. Tout déplacement relatif entre la bobine et l'aimant engendre, aux bornes de la bobine, une force électromotrice qui est proportionnelle à la vitesse du mouvement.

D'une manière traditionelle, l'on fait débiter cette force électromotrice dans une résistance d'amortissement placée directement en parallèle sur le géophone de façon à produire un amortissement dont la valeur est typiquement entre 60% et 70%. Vu du géophone, la résistance d'amortissement est en série avec la résistance interne du géophone et cause par conséquent un effet de diviseur de tension, réduisant ainsi le signal présenté au préamplificateur de tension. L'impédance d'entrée du préamplificateur est suffisamment élevée pour ne pas modifier l'amortissement. Le montage en diviseur de tension présente l'inconvénient de réduire la sensibilité du géophone. Il est possible de remédier à ce premier inconvénient soit en mettant plusieurs géophones en série soit en augmentant le nombre de tours de la bobine.

Ces deux solutions ont leur propre inconvénient à savoir d'augmenter le volume du capteur proprement dit et/ou d'accroître sa résistance interne.

Dans le cas de l'acquisition de signaux sismiques de fond, les capteurs sont situés à l'intérieur d'une sonde allongée de diamètre extérieur inférieur à 100 mm, adaptée à être suspendue au bout d'un cable électrique à l'intérieur d'un sondage. Jusqu'à très récemment, l'on utilisait un capteur uni-axial formé par un ensemble de quatre géophones en série. Néanmoins les progrès en matière d'interprétation sismique ont conduit très rapidement à envisager l'acquisition de signaux sismiques suivant trois axes orthogonaux. De plus, dans le cas des sondages déviés, il est souhaitable que l'un des trois axes orthogonaux soit vertical, ce qui tout naturellement amène à considérer l'utilisation de capteurs suspendus. L'utilisation de trois capteurs orthogonaux suspendus, chacun des capteurs étant formé par quatre géophones en série, nécessite une structure mécanique complexe et volumineuse.

Or des études récentes ont montré que le poids de la sonde sismique devait être aussi faible que possible, de manière à obtenir un meilleur couplage acoustique entre le capteur et la paroi du sondage. Cette condition de poids s'oppose malencontreusement au développement précité.

D'autre part l'accroîssement du nombre de tours de la bobine, donc de la résistance interne du capteur, conduit à augmenter la résistance d'entrée de l'amplificateur et sa résistance de contre-réaction, pour atteindre, très rapidement, des valeurs élevées non recommandées autour de l'amplificateur. Cette limitation supérieure est d'autant plus contraignante du fait que le circuit d'amplification est soumis à des températures élevées, pouvant atteindre 200 °C.

Un but de l'invention est donc de garantir le transfert optimal de l'énergie engendrée par le géophone à l'entrée du préamplificateur.

Un autre but de l'invention est de minimiser l'effet de bruit à l'entrée du préamplificateur.

Dans le dispositif, selon l'invention, de détection sismique comprenant un capteur sismique composé d'un ou plusieurs géophones, une résistance d'amortissement et un amplificateur, ladite résistance d'amortissement est essentiellement constituée d'une résistance placée en série entre ledit capteur et ledit amplificateur.

Selon un mode de réalisation préférentiel la résistance d'amortissement est composée de deux résistances égales, dont l'une est branchée en série avec l'entrée positive de l'amplificateur tandis que l'autre est branchée en série avec l'entrée négative de l'amplificateur.

Le procédé, selon l'invention, de détection sismique dans lequel l'on amortit les signaux électriques engendrés par un capteur formé d'un ou plusieurs géophones en série et l'on amplifie lesdits signaux électriques amortis, consiste à faire participer à l'amplification tout le courant débité par le capteur.

La description qui va suivre permettra de mieux comprendre l'invention.

La Fig. 1 est un schéma électrique du circuit de préamplification suivant la technique connue.

La Fig. 2 est un schéma électrique du circuit de préamplification dans lequel la résistance d'amortissement est placée en série entre le capteur et l'amplificateur.

La Fig. 3 est un schéma électrique du circuit de préamplification suivant un mode de réalisation préféré.

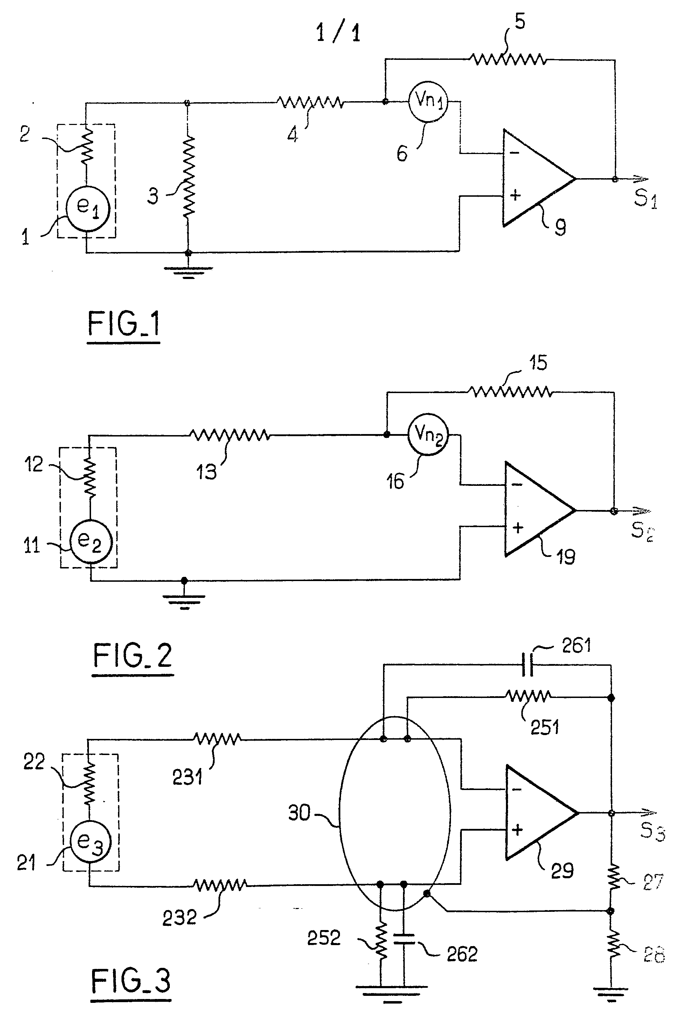

Nous allons tout d'abord décrire brièvement un circuit de préamplification classique. Le capteur sismique à détection de vitesse ou électromagnétique est symbolisé dans la Fig. 1 par une source de tension 1 délivrant une force électromotrice $e_1$, à laquelle l'on fait correspondre une résistance interne 2 de valeur $R_2$. Une résistance 4 d'amortissement de valeur $R_3$ est placée en parallèle avec le capteur, l'une de ses bornes étant connectée à la masse.

Ce montage classique forme un diviseur de tension, la tension aux bornes de la résistance d'amortissement étant égale à:

$$V(R_3) = e_1 \cdot R_3 / (R_2 + R_3)$$

Cette tension $V(R_3)$ est appliquée, par l'intermédiaire d'une résistance d'entrée 4 de valeur $R_4$, à l'entrée négative d'un amplificateur 9. Ce dernier est muni d'une boucle de contreréaction négative constituée d'une résistance 5, d'une valeur $R_5$ nettement supérieure à $R_3$, de sorte que le gain $g_1$ de l'amplificateur 9 est égal à:

$$g_1 = - R_5 / R_4$$

Une source de tension 6, placée à l'entrée négative de l'amplificateur 9, symbolise une tension $Vn_1$ équivalente au bruit électrique du circuit précédant l'amplificateur 9.

Il est donc possible d'exprimer la tension de sortie $s_1$ de l'amplificateur en fonction de $e_1$ et de $Vn_1$:

$$s_1 = g_1 \cdot e_1 \cdot R_3 / (R_2 + R_3) + g_1 \cdot Vn_1$$

Le rapport $R_3 / (R_2 + R_3)$ évidemment inférieur à 1, est typiquement de l'ordre de 60%, de sorte que la contribution de la force électromotrice $e_1$ aus signal $s_1$ est largement diminuée au détriment du bruit électrique $Vn_1$. D'une autre manière, l'on peut écrire l'expression suivante:

$$\frac{\text{Le Gain de } e_1}{\text{Le Gain de } Vn_1} = \frac{R_3}{R_2 + R_3} < 1$$

Il est donc impératif, dans l'arrangement décrit ci-dessus, de maintenir le bruit électrique aussi faible que possible, c'est à dire d'utiliser des valeurs de résistance $R_2$ et $R_3$ reltaivement faibles, de l'ordre de 300 à 1000 ohms.

Cette condition limite évidemment la sensibilité du capteur, puisque qu'elle détermine le nombre maximal de tours de la bobine.

En se référant à la Fig. 2, la résistance 13 d'amortissement de valeur $R_{13}$ est placée en série avec le capteur qui est représenté par une source de tension 11 délivrant une tension $e_2$ et une résistance interne 12 de valeur $R_{12}$. Les résistances 12 et 13 constituent donc la résistance d'entrée de l'amplificateur 19 dont le gain est dénommé $g_2$.

L'amplificateur de tension 19 est par exemple l'amplificateur opérationnel à bruit faible HA-5130 fabriqué par Harris Co.

Le capteur débite donc un courant dans une résistance d'amortissement 13, pour obtenir un amortissement de 60 ou 70%, mais c'est ce même courant qui participe à l'amplification.

Comme dans le montage précédent, l'on représente le bruit électrique par une source de potentiel 16 délivrant une tension $Vn_2$ qui vient s'ajouter à l'entrée négative de l'amplificateur 19; une résistance 15 d'une valeur $R_{15}$ assure la contreréaction négative de l'amplificateur 19.

Le gain $g_2$ de l'amplificateur est en pratique donné par le rapport de la résistance de contreréaction à la somme de la résistance interne 12 du capteur et de la résistance d'amortissement 13. La tension de sortie $s_2$ peut donc s'exprimer de la façon suivante:

$$s_2 = (e_2 + Vn_2) \cdot R_{15} / (R_{12} + R_{13})$$

La tension de sortie $s_2$ n'est donc pas dégradée par le bruit électrique dans la même proportion que dans le montage classique, ce qui peut se traduire par l'expression suivante:

$$\frac{\text{Le Gain de } e_2}{\text{Le Gain de } Vn_2} = 1$$

Il est donc tout à fait possible, grâce à un tel montage, d'augmenter la sensibilité du capteur, en ajoutant des tours à la bobine par example, sans pour autant augmenter la contribution du bruit électrique au signal $s_2$.

Un mode de réalisation plus élaboré est celui de la Fig. 3. Le capteur est représenté, comme précedemment, par une source de tension 21 délivrant une tension $e_3$ et une résistance interne 22 de valeur $R_{22}$. Dans ce montage, la résistance d'amortissement est composée de deux résistances 231 et 232 égales à la moitié de la valeur de la résistance d'amortissement $R_{13}$, chacune d'elle étant placée respectivement en série avec chacune des sorties du capteur. Les sorties des deux résistances 231 et 232 attaquent respectivement les deux entrées de l'amplificateur 29.

De plus la liaison entre les deux résistances 231 et 232 et l'amplificateur est munie d'un anneau de garde 30 pour une meilleur immunité au bruit électrique en température. La tension appliquée à l'anneau de garde est égale à $s_3 / 2$ et est prise au niveau d'un diviseur de tension formé par deux résistances égales 27 et 28.

La contre-réaction de l'amplificateur 29 est assurée à l'entrée négative par une résistance 251 placée en parallèle avec une capacité 261. La réjection du mode commun est assurée par un montage différentiel comportant une résistance 252 placée en parallèle avec une capacité 262 sur l'entrée positive. Les résistances 251 et 252 sont égales et déterminent le gain de l'amplificateur 29. Les capacités 261 et 262 sont égales et déterminent la fréquence de coupure haute.

Ce montage différentiel présente une meilleure immunité aux modes communs.

Le gain $g_3$ d'un tel montage peut s'exprimer de la façon suivante:

$$g_3 = \frac{e_3 \cdot R_{251}}{R_{231} + R_{22}/2}$$

Le gain $g_3$ est choisi de façon à assurer au signal $s_3$ une sensibilité de 2500 V/m/s . Un tel montage permet d'utiliser un capteur électromagnétique dont l'impédance interne est de l'ordre de 3,5 kΩ et dont la sensibilité est de l'ordre de 80 V/m/s. Une résistance d'amortissement de 12 kΩ, soit 6 kΩ pour chacune des résistances 231 et 232, combiné avec une résistance de contre-réaction de 220 kΩ assure un gain d'environ 30.

L'utilisation d'un tel dispositif de détection permet de réduire, d'une manière appréciable, le nombre de géophones placés en série; il résoud, d'une manière élégante, les problèmes d'encombrement et de bruit électrique décrits auparavant.

## Revendications

1. Dispositif de détection sismique comprenant un capteur (11, 12) composé d'un ou plusieurs géophones, une résistance d'amortissement (13) et un amplificateur (19), caractérisé en ce que ladite résistance d'amortissement (13) est essentiellement constituée d'une résistance placée en série entre ledit capteur (11, 12) et ledit amplificateur (19).

2. Dispositif selon la revendication 1, caractérisé en ce que la valeur de ladite résistance d'amortissement est située dans une plage de 10 kΩ à 15 kΩ.

3. Dispositif selon l'une des revendications 1 et 2, caractérisé en ce que la valeur de ladite résistance d'amortissement (13) est trois à quatre fois la valeur de la résistance interne du capteur (12).

4. Dispositif selon l'une des revendications 1 à 3, caractérisé en ce que la résistance d'amortissement (13) est constituée de deux résistances (231, 232) de valeur égale, dont l'une (232) est branchée en série avec l'entrée positive de l'amplificateur (29) et l'autre (231) est branchée en série avec l'entrée négative de l'amplificateur (29).

5. Dispositif selon la revendication 4, caractérisé en ce que les liaisons électriques entre les deux résistances (231, 232) (21, 22) et les entrées correspondantes de l'amplificateur (29) sont munies d'un anneau de garde (30).

6. Dispositif selon la revendication 5, caractérisé en ce que le potentiel de l'anneau de garde (30) est égal à la moitié du potentiel de sortie de l'amplificateur (29).

7. Dispositif selon l'une des revendications 1 à 6, caractérisé en ce que la contre-réaction de l'amplificateur est assurée par deux réseaux ayant des composants identiques (251, 252, 261, 262) en parallèle.

8. Dispositif selon l'une des revendications 1 à 7, caractérisé en ce qu'il est contenu dans une sonde de diagraphie.

9. Procédé de détection sismique dans lequel l'on amortit les signaux électriques engendrés par un capteur sismique composé d'un ou plusieurs géophones en série et l'on amplifie lesdits signaux électriques amortis, caractérisé en ce que l'on fait participer à l'amplification pratiquement tout le courant débité par ledit capteur.

10. Procédé selon la revendication 9, caractérisé par le fait que l'on amplifie lesdits signaux électriques d'une manière différentielle.

## Patentansprüche

1. Seismische Detektoranordnung, umfassend einen Aufnehmer (11, 12), aus einem oder mehreren Geophonen bestehend, einen Dämpfungswiderstand (13) und einen Verstärker (19), dadurch gekennzeichnet, dass der genannte Dämpfungswiderstand (13) im wesentlichen von einem Widerstandselement gebildet ist, das in Serie zwischen den genannten Aufnehmer (11, 12) und den genannten Verstärker (19) gelegt ist.

2. Seismische Detektoranordnung nach Anspruch 1, dadurch gekennzeichnet, dass der Wert des genannten Dämpfungswiderstandselementes in einem Bereich von 10 kΩ bis 15 kΩ liegt.

3. Seismische Detektoranordnung nach einem der Ansprüche 1 und 2, dadurch gekennzeichnet, dass der Wert des genannten Dämpfungswiderstandselementes (13) das Drei- bis Vierfache des Wertes des Innenwiderstandes des Aufnehmers (12) beträgt.

4. Seismische Detektoranordnung nach einem der Ansprüche von 1 bis 3, dadurch gekennzeichnet, dass das Dämpfungswiderstandselement (13) aus zwei Widerstandselementen (231, 232) gleichen Wertes besteht, von denen das eine in Serie mit dem positiven Eingang des Verstärkers (29) und das andere (231) in Serie mit dem negativen Eingang des Verstärkers (29) gelegt ist.

5. Seismische Detektoranordnung nach Anspruch 4, dadurch gekennzeichnet, dass die elektrischen Verbindungen zwischen den beiden Widerstandselementen (231, 232) und den entsprechenden Eingängen des Verstärkers (29) mit einem Überwachungsring (30) versehen sind.

6. Seismische Detektoranordnung nach Anspruch 5, dadurch gekennzeichnet, dass das Potential des Überwachungsringes (30) gleich der Hälfte des Ausgangspotentials des Verstärkers (29) ist.

7. Seismische Detektoranordnung nach einem der Ansprüche von 1 bis 6, dadurch gekennzeichnet, dass die Gegenkopplung des Verstärkers durch zwei identische Komponenten aufweisende parallel geschaltete Netzwerke (251, 252, 261, 262) sichergestellt wird.

8. Seismische Detektoranordnung nach einem der Ansprüche von 1 bis 7, dadurch gekennzeichnet, dass sie in einer Diagraphiesonde enthalten ist.

9. Seismisches Erfassungsverfahren, bei dem man die von einem aus einem oder mehreren in Serie geschalteten Geophonen bestehenden seismischen Aufnehmer erzeugten elektrischen Signale dämpft und die gedämpften elektrischen Signale verstärkt, dadurch gekennzeichnet, dass man praktische den gesamten vom Aufnehmer abgegebenen Strom an der Verstärkung teilnehmen lässt.

10. Verfahren nach Anspruch 9, dadurch gekennzeichnet, dass man die genannten elektrischen Signale in differentieller Weise verstärkt.

## Claims

1. Seismic detection apparatus comprising a seismic pick-up (11, 12) made of one or more geophones, a damping resistance (13), and an amplifier (19), characterized in that said damping resistance (13) is essentially constituted by a resistance connected in series between said pick-up (11, 12) and said amplifier (19).

2. Apparatus according to claim 1, characterized in that the value of said damping resistance lies in the range of 10 kΩ to 15 kΩ

3. Apparatus according to any one of claims 1 and 2, characterized in that the value of said damping resistance (13) is three to four times the value of the internal resistance of the pick-up (12).

4. Apparatus according to any one of claims 1 to 3, characterized in that the damping resistance (13) is made of two equal value resistances (231, 232), one of which (232) is connected in series with the positive input of the amplifier (29) while the other one (231) is connected in series with the negative input of the amplifier (29).

5. Apparatus according to claim 4, characterized in that the electrical connections between the two resistances (231, 232) and the corresponding inputs of the amplifier (29) are fitted with a guard ring (30).

6. Apparatus according to claim 5, characterized in that the potential of the guard ring (30) is equal to half the output potential of the amplifier (29).

7. Apparatus according to any one of claims 1 to 6, characterized in that amplifier negative feedback is provided by two networks having identical components in parallel (251, 252, 261, 262).

8. Apparatus according to any one of claims 1 to 7, characterized in that it is contained in a logging sonde.

9. A seismic detection method in which the electrical signals generated by a pick-up made of one or more geophones connected in series are damped and the damped electrical signals are amplified, characterized in that practically all of the current delivered by said pick-up is made to participate in the amplification.

10. A method according to claim 9, characterized by the fact that said electrical signals are differentially amplified.

FIG_1

FIG_2

FIG_3